Europäisches Patentamt

European Patent Office

Office européen des brevets

(11) Publication number: **0 086 333**
**B1**

## EUROPEAN PATENT SPECIFICATION

(45) Date of publication of patent specification: **25.06.86**

(21) Application number: **83100237.3**

(22) Date of filing: **13.01.83**

(51) Int. Cl.⁴: **H 03 K 5/02,** H 03 K 19/003,
H 03 K 19/096, G 11 C 7/02

(54) **A digital circuit.**

(30) Priority: **13.01.82 JP 3787/82**

(43) Date of publication of application:
**24.08.83 Bulletin 83/34**

(45) Publication of the grant of the patent:
**25.06.86 Bulletin 86/26**

(84) Designated Contracting States:
**DE FR GB NL**

(56) References cited:
**EP-A-0 027 905**
**EP-A-0 030 813**
**EP-A-0 032 017**
**DE-B-2 904 674**
**US-A-4 123 799**
**US-A-4 208 730**

(73) Proprietor: **NEC CORPORATION**
**33-1, Shiba 5-chome, Minato-ku**
**Tokyo 108 (JP)**

(72) Inventor: **Nakaizumi, Kazuo**
**Nippon Electric Co., Ltd. 33-1, Shiba Gochome**
**Minato-ku Tokyo (JP)**

(74) Representative: **Glawe, Delfs, Moll & Partner**
**Patentanwälte**
**Postfach 26 01 62 Liebherrstrasse 20**
**D-8000 München 26 (DE)**

Courier Press, Leamington Spa, England.

**Description**

The present invention relates to a digital circuit, and more particularly to a precharge circuit for a digital circuit employing field-effect transistors.

Digital circuits widely adopt the precharge technique in which predetermined circuit nodes are all charged to a predetermined potential and subsequently charges accumulated at the selected circuit nodes are discharged to determine logic levels, because such precharge technic is advantageous in view of low power consumption and a high speed operation.

For example, in a memory circuit, a plurality of digit lines to which memory cells are connected, are precharged with a precharge voltage source by conducting precharge transistors coupled between the respective digit lines and the precharge voltage source prior to each operation. In performing the precharge, a precharge control signal is commonly applied to the precharge transistors and used to control them. The precharge control signal is usually generated as an output signal of an inverter which receives a basic control signal such as a chip enable signal and with a predetermined slope it changes from one of binary logic levels which makes the precharge transistors non-conducting to the other of the binary logic levels which makes the precharge transistors conducting.

When the precharge control signal changes from above one of the binary logic levels towards the other of the binary logic levels, a potential at gates of the precharge transistors similarly changes and the precharge transistors become conducting to feed circuit nodes such as digit lines with currents. While, a potential at the circuit nodes to be charged is gradually raised as time elapses. This raise of potential at the circuit nodes functions to reduce a gate-source voltage bias of the precharge transistors. Therefore, amount of currents fed through the precharge transistors is increased in accordance with shift in potential of the precharge control signal towards the other of the binary logic levels till a predetermined time point, and then it is decreased in accordance with the potential raise at the circuit nodes to be charged. Accordingly, the amount of currents fed throughout the precharge inevitably takes a peak value. In general, if a current having a large peak values flows in a circuit, then various harmful noises are generated thereby and in the worst case malfunction of the circuit would be caused.

In order to reduce the peak value of the current, it would be introduced to reduce conductances of the precharge transistors or to make the change of the precharge control slower in order to moderate the peak value of the precharge current. However, if the technic would be employed, there would be caused a disadvantage that the time required for completing the precharge would be prolonged, resulting in a low speed operation.

From EP—A1—0027905 there has been known a digital circuit for charging a circuit node as defined in the pre-characterizing portion of claim 1. In this prior art circuit, although the first signal controlling the first charging transistor is charged with three successively different rates of change, the circuit node to be charged is not disconnected from the second terminal by the second transistor until the time when the first signal has assumed its third rate of change. At this time the node has been charged only to a very small potential, and therefore substantially all the charging of the circuit node is controlled by the first signal having its third rate of change. Moreover, the first signal is charged up to a potential exceeding the power supply potential and subsequently returns to said power supply potential. For these reasons the charging current to the circuit node will have a relatively high peak value.

It is an object of the present invention to provide a circuit of the aforementioned kind in which the peak value of the charging current to a circuit node is effectively suppressed to prevent the generation of harmful noices without causing a substantial prolonged charging time.

According to the invention this object is solved by a circuit as defined in claim 1. Claims 2 and 3 relate to further advantageous improvements of the circuit.

In the circuit according to the invention the circuit node is effectively charged already during the time when the first signal has its first and second rates of change. The second rate of change which is smaller than the first rate is effective for suppressing a peak value of the charging current. Although the circuit node is further charged during the time when the first signal has its third rate of change, this makes only a small contribution to the charging of the circuit node because the circuit node had already been charged to a level rather close to the final level during the time of the second rate of change of the first signal.

Thus, during the whole charging operation the effective conductance of the precharged transistor is limited to a relatively low value and hence the peak value of the charging current fed through the precharge transistor is also limited to a small value. As a result, a wave form of the precharge current is made moderate throughout the precharge operation without prolonging a period of time of the precharge operation.

Fig. 1 is a circuit diagram showing a precharge circuit in the prior art;

Fig. 2 is a timing chart for explaining an operation of the circuit of Fig. 1;

Fig. 3 is a circuit diagram of a first preferred embodiment of the present invention;

Fig. 4 is a timing chart for explaining an operation of the circuit of Fig. 3;

Fig. 5 is a circuit diagram of one example of application of the present invention;

Fig. 6 is a timing chart for explaining an operation of the circuit of Fig. 5;

Fig. 7 is a circuit diagram of a second preferred embodiment of the present invention;

Fig. 8 is a circuit diagram of a third preferred embodiment of the present invention;

Fig. 9 is a timing chart for Fig. 8; and

Fig. 10 is a timing chart for representing the comparison between the prior art and the present invention:

Now with reference to the drawings, the present invention will be explained in detail. In the following explanation, a CMOS structure in which N-channel field effect transistors and P-channel field effect transistors are included is employed by way of example and the logic "1" or high level corresponds to a power supply voltage (Vcc) while the logic "0" or low level corresponds to the ground potential.

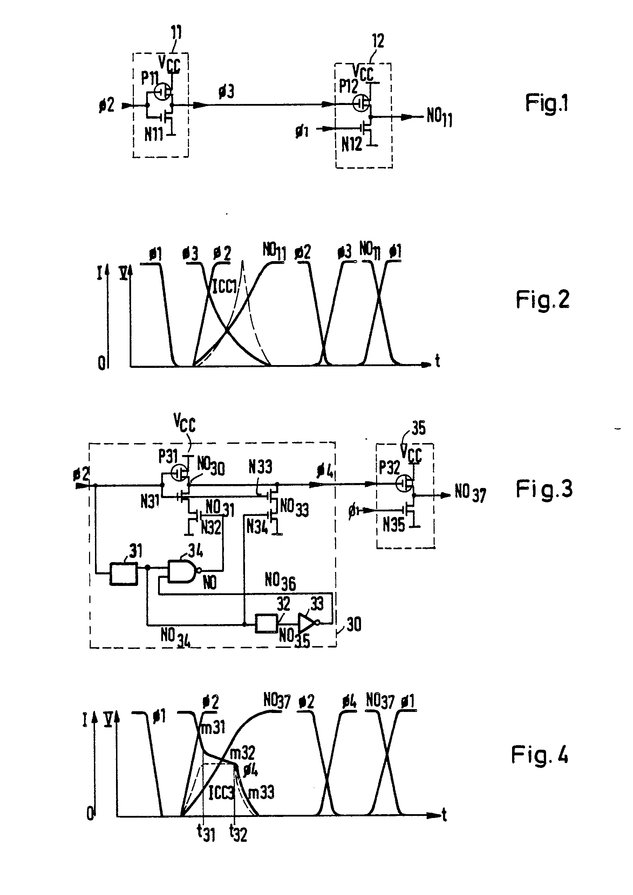

First, with reference to Figs. 1 and 2 a precharge circuit according to the prior art will be described.

In Fig. 1, a precharge signal generator portion 11 for generating a precharge control signal $\phi_3$ and a portion 12 forming a precharge is illustrated. In this circuit, P-channel transistors $P_{11}$ and $P_{12}$, and N-channel transistors $N_{11}$ and $N_{12}$ are employed, and a node $NO_{11}$ is precharged. The precharge signal generator portion 11 is constructed of CMOS inverter circuit consisting of the transistors $P_{11}$ and $N_{11}$.

Now description will be made on the operation of the circuit in the prior art with reference to a timing chart shown in Fig. 2. First, when a first control signal $\phi_1$ is at "1"-level (Vcc), the transistor $N_{12}$ is turned ON to bring the node $NO_{11}$ to be charged to "0"-level (ground level). Subsequently, when the first control signal $\phi_1$ takes "0"-level, the transistor $N_{12}$ is turned OFF, and then if a second control signal $\phi_2$ becomes "1"-level, then the precharge control signal $\phi_3$ falls in potential gradually from "1"-level (Vcc potential) and takes "0"-level, and hence the transistor $P_{12}$ is turned ON to start charging. As a result, the node $NO_{11}$ to be charged is brought to a charged level, i.e., "1"-level. Next, when the second control signal $\phi_2$ becomes "0"-level, the precharge control signal $\phi_3$ becomes "1"-level, hence the transistor $P_{12}$ is turned OFF. Subsequently when the first control signal $\phi_1$ becomes "1"-level, the node $NO_{11}$ to be charged is turned to "0"-level through the transistor $N_{12}$.

The above-mentioned circuit in the prior art had the following disadvantage. That is, in Fig. 2, when the precharge control signal $\phi_3$ changes from "1"-level to "0"-level, the node $NO_{11}$ to be charged would be raised in potential, but at this moment a large peak value would arise in the charging current $I_{cc1}$ of the $NO_{11}$. In general, if a current having a large peak value flows in a circuit, then various harmful noises are generated thereby, and so, it is undesirable. In order to reduce this peak value, it would be possible to consider reducing the size of the transistor $N_{11}$ to thereby moderate the slope of the potential fall of the precharge signal $\phi_3$ or the size of the charging transistor $P_{12}$ could be reduced. However, if these methods were employed, there would be a disadvantage that the time required for charging the node $NO_{11}$ would be prolonged.

Now description will be made on a first preferred embodiment of the present invention with reference to Figs. 3 and 4.

As shown in Fig. 3, a precharge circuit is basically composed of a precharge signal generator portion 30 for generating a precharge control signal $\phi_4$ and a precharge portion 35 responsive to the precharge control signal $\phi_4$ for charging a node $NO_{37}$. The precharge portion 35 includes a P-channel transistor $P_{32}$ as a precharge transistor coupled between the node $NO_{37}$ and a power supply terminal $V_{cc}$ and an N-channel transistor $N_{35}$ coupled between the node $NO_{37}$ and the ground potential. A circuit structure of the precharge portion 35 is basically the same as the portion 12 of Fig. 1. The transistor $P_{32}$ charges the node $NO_{37}$ in response to "0" or low level of the precharge control signal $\phi_4$. The N-channel transistor $N_{35}$ discharges the charge at the node $NO_{37}$ in response to "1" or high level of a first control signal $\phi_1$.

The precharge control signal generator portion 30 receives a second control signal $\phi_2$ as a basic signal for controlling precharge operation and generates the precharge control signal $\phi_4$. The precharge control signal generator portion 30 includes a P-channel transistor $P_{31}$ coupled between the power supply terminal ($V_{cc}$) and an output node $NO_{30}$ and having a gate receiving the signal $\phi_2$ N-channel transistors $N_{31}$ and $N_{32}$ connected in series between the output node $NO_{30}$ and the ground potential, N-channel transistors $N_{33}$ and $N_{34}$ connected in series between the output node $NO_{30}$ and the ground potential. Gates of the transistors $N_{31}$ and $N_{33}$ receive the signal $\phi_2$. For controlling the transistors $N_{32}$ and $N_{34}$, delay circuits 31 and 32, a NAND gate 34 and an inverter 33 are provided. The delay circuit 31 receives the signal $\phi_2$ and an output signal of the delay circuit 31 is applied to a gate of the transistor $N_{34}$, a first input terminal of the NAND gate 34, and an input terminal of the delay circuit 32. An output of the delay circuit 32 is led to a second input terminal of the NAND gate 34 through the inverter 33. An output signal of the NAND gate 34 is applied to a gate of the transistor $N_{32}$.

In this circuit, an effective conductance of the series circuit of the transistors $N_{31}$ and $N_{32}$ is set far larger than that of the series circuit of the transistors $N_{33}$ and $N_{34}$. For achieving such provision, if the conductances of the transistors $N_{32}$ and $N_{34}$ are made substantially the same, the conductance of the transistor $N_{31}$ is made larger than that of the transistor $N_{33}$.

Now the operation of this preferred embodiment will be explained with reference to a timing chart shown in Fig. 4.

When the first control signal $\phi_1$ is at "1"-level, the transistor $N_{35}$ is turned ON and brings node $NO_{37}$ to be charged to "0"-level i.e., discharged. Subsequently the first control signal $\phi_1$ becomes "0"-level and the transistor $N_{35}$ is turned OFF. In this instance, the signal $\phi_2$ is at "0" level, and the output signal at a node $NO_{34}$ of the delay circuit 31 is still at "0" level, and therefore the output signal at a node $NO_{32}$ of the gate 34 is at "1" level. Therefore, the transistor $N_{32}$ is conducting. Next, when the second control signal $\phi_2$ changes from "0"-level to "1"-level, then the transistor $P_{31}$ is turned OFF and the transistor $N_{31}$ and $N_{33}$ is turned ON, so that the precharge control signal $\phi_4$ begins to fall in potential from "1"-level ($V_{cc}$ potential) with a large gradient $m_{31}$ that is determined by the serial ON resistances of the transistors $N_{31}$ and $N_{32}$. Thereby the transistor $P_{32}$ is turned ON to start charging of the node $NO_{37}$ to be charged. Then, as the potential of the precharge signal $\phi_4$ falls, the conductance of the transistor $P_{32}$ rises, and hence, the charging current $I_{cc3}$ for the node $NO_{37}$ to be charged is gradually increased. On the other hand, after the second control signal $\phi_2$ is turned to "1"-level, the node $NO_{34}$ is brought to "1"-level via the delay circuit 31, and hence the transistor $N_{34}$ is turned ON. In this instance, the node $NO_{32}$ is brought to "0"-level through the NAND circuit 34 because the node $NO_{34}$ is at "1" level and the node $NO_{35}$ is still at "0" level by a delay time of the delay circuit 32 to set the node $NO_{36}$ at "1" level. Hence, the transistor $N_{32}$ is turned OFF. (The moment when the transistor 32 is turned OFF is indicated by $t_{31}$.) In other words, at the moment $t_{31}$, the current path which causes potential drop of the precharge signal $\phi_4$ is switched from the transistors $N_{31}$ and $N_{32}$ to the transistors $N_{33}$ and $N_{34}$. By selecting the sizes of the transistors $N_{33}$ and $N_{34}$ smaller (for instance by a factor of 1/5) than the transistor sizes of the transistors $N_{31}$ and $N_{32}$, the precharge control signal $\phi_4$ present a moderate slope indicated by $m_{32}$ that is determined by the ON resistances of the transistors $N_{33}$ and $N_{34}$. Consequently, the rise of the conductance of the transistor $P_{32}$ also becomes moderate or suppressed. Therefore, the charging current $I_{cc3}$ becomes nearly constant. Subsequently, the node $NO_{35}$ becomes "1"-level via the delay circuit 32 after a delay time of the delay circuit 32, and the node $NO_{36}$ becomes "0"-level via the inverter circuit 33. Then, the node $NO_{32}$ again becomes "1"-level via the NAND circuit 34, and consequently, the transistor $N_{32}$ is turned ON. (The moment when the transistor $N_{32}$ is turned ON is indicated by $t_{32}$.) Thereby, the potential drop of the precharge control signal $\phi_4$ again takes a steep slope indicated by $m_{33}$ towards OV. Therefore, the conductance of the transistor $P_{32}$ again starts quickrise, but at the moment $t_{32}$ in Fig. 4, the potential at the node $NO_{37}$ to be charged has already come close to the $V_{cc}$ potential (for instance 80% or higher of the $V_{cc}$ potential), and hence the value of the charging current $I_{cc3}$ begins to reduce. Subsequently, when the second input signal $\phi_2$ becomes "0"-level, the transistor $P_{31}$ is turned ON, the transistors $N_{31}$ and $N_{33}$ are turned OFF, hence the precharge control signal $\phi_4$ takes "1" level, and the transistor $P_{32}$ is turned OFF. Nextly, the first control signal $\phi_1$ takes "1" level to bring the node $NO_{37}$ to be charged to "0"-level.

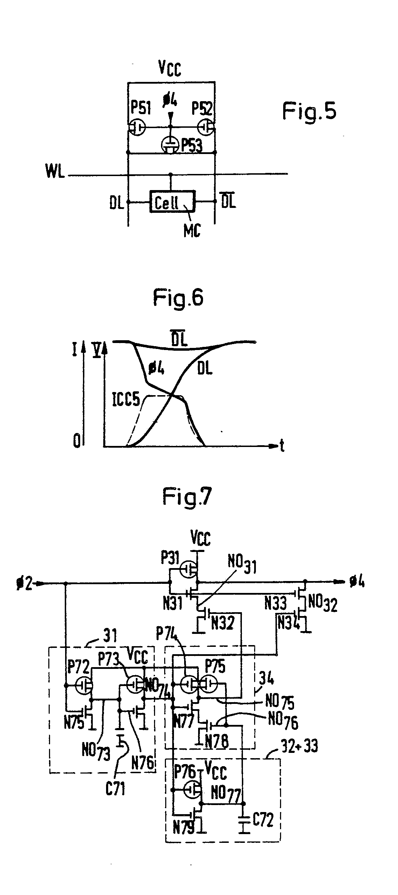

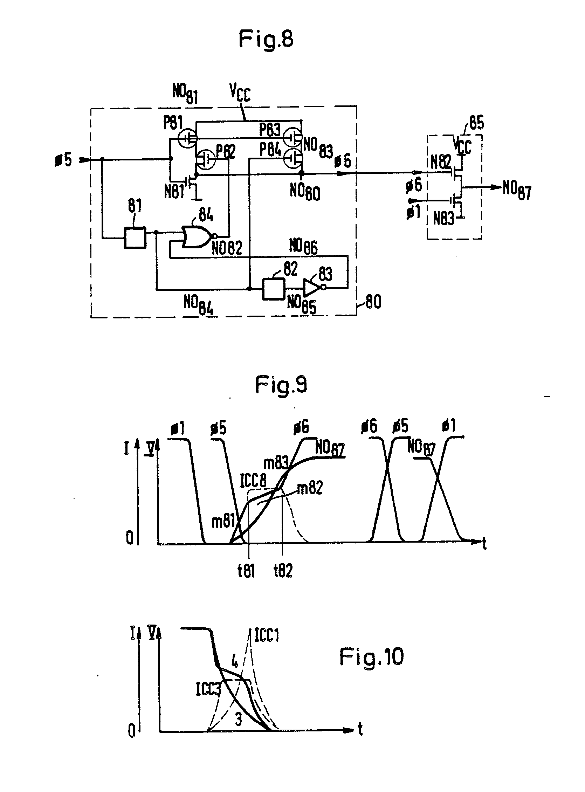

Now one example of application of this invention will be shown. That is, with regard to the case where the above-described precharge control signal $\phi_4$ is used as a precharge control signal for a digit line in a memory circuit, explanation will be made with reference to Figs. 5 and 6.

In Fig. 5, a memory cell MC is arrayed at an intersection of a word line WL and a pair of digit lines DL and $\overline{DL}$. In this structure, the pair of digit lines DL and $\overline{DL}$ are precharged by P-channel transistors $P_{51}$, $P_{52}$ and $P_{53}$ in response to "0"-level of the precharge control signal $\phi_4$.

Now the operation of the circuit in Fig. 5 will be explained with reference to a timing chart in Fig. 6. The threshold voltage of the transistors $P_{51}$ to $P_{53}$ is represented by $V_{TP}$. During read or write operations the precharge control signal $\phi_4$ is at a "1"-level, and hence the transistors $P_{51}$ to $P_{53}$ are in an OFF state. In addition, at a time point when the above-mentioned operation has completed, one (DL) of the digit lines is at "0" level. Subsequently when it has transferred to a precharge state, the precharge control signal $\phi_4$ begins to fall in potential, and if the potential becomes a potential equal to or lower than $V_{cc}-|V_{TP}|$, then the transistors $P_{51}$ to $P_{53}$ are turned ON, and thereby the digit line DL begins to be charged. As the potential of the precharge control signal $\phi_4$ falls, the conductances of the transistors $P_{51}$ to $P_{53}$ are increased, and hence the value of the charging current $I_{cc5}$ for the digit line DL becomes large gradually. Subsequently, when the slope of the precharge control signal $\phi_4$ becomes moderate the rise of the conductances of the transistors $P_{51}$ to $P_{53}$ becomes moderate. Consequently, the charging current $I_{cc5}$ becomes nearly constant. After the potential of the DL line has risen to about 80 to 90% of the $V_{cc}$ potential, the slope of the precharge control signal $\phi_4$ again becomes steep, then the conductances of the transistors $P_{51}$ to $P_{53}$ begin to rise and the digit line rises towards the $V_{cc}$ potential, but the charging current is reduced.

In general, in a memory circuit, the large peak current appearing as a charging current for digit lines, is one of the important points which becomes a problem upon design of a memory circuit and also upon designing a system employing the memory circuit. More particularly, although a capacitance of a digit line in a memory circuit is a small value (for instance 1 pF) with respect to a single digit line only, as a memory capacity becomes large-sized, the number of the digit lines is increased, and the total capacitance for the entire digit lines becomes a large value. For instance, in a memory circuit of 16 K bits, the number of the digit lines is sometimes 128, and hence the peak current value produced upon charging these digit lines amounted in the prior art as large as 150 mA. In a high-speed large-capacity memory circuit that is remarkable in progress in recent years, a large number of digit lines must be charged within a short period, and accordingly, as explained above with respect to the illustrated example, it is obvious that the present invention can bring about a large advantage.

Now, a second preferred embodiment of the present invention will be explained with reference to Fig. 7.

This embodiment shows a detailed example of the embodiment of Fig. 3. As will be apparent from the figure, in this preferred embodiment the logic blocks in the above-described first preferred embodiment are replaced by transistors of CMOS constructions. Accordingly, the operation is similar to the case of the above-described first preferred embodiment. Hence, only the correspondance betwen Figs. 3 and 7 will be explained here. P-channel transistors $P_{72}$ to $P_{76}$ and N-channel transistors $N_{75}$ to $N_{79}$ are employed. The transistors $P_{72}$, $N_{75}$, $P_{73}$ and $N_{76}$ and the additive capacitance $C_{71}$ form a CMOS delay circuit 31 which corresponds to the delay circuit indicated with the same reference number in Fig. 3. The transistors $P_{76}$ and $N_{79}$ and the additive capacitance $C_{72}$ form a CMOS delay circuit and an inverter circuit in combination 32 and 33 which corresponds to the delay circuit 32 and the inverter circuit 33 in Fig. 3. The transistors $P_{74}$, $P_{75}$, $N_{77}$ and $N_{78}$ form a CMOS NAND circuit 34 which corresponds to the NAND circuit 34 with the same reference number in Fig. 3.

Now a third preferred embodiment of the present invention will be explained with reference to Figs. 8 and 9.

In Fig. 8, a precharge control signal generator portion 80 receives a second control signal $\phi_5$ and generates a precharge control signals $\phi_6$ to be applied to a precharge transistor. A precharge portion 85 includes an N-channel transistor $N_{82}$ coupled between the power supply terminal ($V_{cc}$) and a node $NO_{87}$ to be precharged and an N-channel transistor $N_{83}$ coupled between the node $NO_{87}$ and the ground potential. The transistor $N_{82}$ charges the node $NO_{87}$ in response to a "1" level of the precharge control signal $\phi_6$ while the transistor $N_{83}$ discharges the node $NO_{87}$ in response to a "1"-level of the first control signal $\phi_1$.

The precharge control signal generator portion 80 includes a series circuit of P-channel transistors $P_{81}$ and $P_{82}$ and a series circuit of P-channel transistors $P_{83}$ and $P_{84}$ both connected in series between the power supply terminal ($V_{cc}$) and an output node $NO_{80}$, and an N-channel transistor $N_{81}$ coupled between the node $NO_{80}$ and the ground potential. Delay circuits 81 and 82, an inverter 83 and a NOR gate 84 are provided for controlling the transistors $P_{82}$ and $P_{84}$.

Nextly, description will be made on the operation of the preferred embodiment in Fig. 8 with reference to a timing chart shown in Fig. 9. When the first control signal $\phi_1$ is at "1"-level, the transistor $N_{83}$ is turned ON, and so, the node $NO_{87}$ to be charged is brought to "0"-level. Subsequently, the first control signal $\phi_1$ becomes "0"-level. Hence, the transistor $N_{83}$ is turned OFF. Then, when the second control signal $\phi_5$ changes from "1" level to "0"-level, the transistor $N_{81}$ is turned OFF, while the transistors $P_{81}$ and $P_{83}$ are turned ON, so that the precharge signal $\phi_6$ rises in potential at a slope $m_{81}$ that is determined by ON resistances of the respective transistors $P_{81}$ and $P_{82}$ starting from "0"-level. In response thereto, the transistor $N_{82}$ is turned ON to start charging of the node $NO_{87}$ to be charged, and since the conductance of the transistor $N_{82}$ becomes large, the charging current $I_{cc8}$ for the node $NO_{87}$ to be charged would be increased gradually. On the other hand, when the second control signal $\phi_5$ becomes "0"-level, the node $NO_{84}$ is brought to "0"-level through the delay circuit 81, the transistor $P_{84}$ is turned ON, the node $NO_{82}$ is brought to "1"-level via the NOR circuit 84, and the transistor $P_{82}$ is turned OFF. (The moment when the transistor $P_{82}$ is turned OFF is indicated by $t_{81}$.) In other words, at the moment $t_{81}$, the path of the current for potential rise of the precharge signal $\phi_6$ is switched from the transistors $P_{81}$ and $P_{82}$ to the transistors $P_{83}$ and $P_{84}$. By selecting the transistor sizes of the transistors $P_{83}$ and $P_{84}$ smaller (for instance, by a factor of 1/5) than the transistor sizes of the transistors $P_{81}$ and $P_{82}$, the precharge signal $\phi_6$ can take a moderate slope as indicated by $m_{82}$ which is determined by the ON resistances of the respective transistors $P_{83}$ and $P_{84}$. Consequently, the rise of the conductance of the transistor $N_{82}$ also becomes moderate, and so the charging current $I_{cc8}$ becomes nearly constant. Subsequently, the node $NO_{85}$ is brought to the "0"-level via the delay circuit 82, the node $NO_{86}$ is brought to "1"-level via the inverter circuit 83, the node $NO_{82}$ is again brought to "0"-level via the NOR circuit 84 and the transistor $P_{82}$ is turned ON. (The moment when the transistor $P_{82}$ is turned on is indicated by $t_{82}$). As a result, the precharge control signal $\phi_6$ again takes a steep slope as indicated by $m_{83}$ and increases towards the $V_{cc}$ potential.

Consequently, the conductance of the transistor 82 again makes abrupt rise. However, at the moment $t_{82}$ in Fig. 9, the potential of the node $NO_{87}$ to be charged is close to the finally reaching potential (for instance, assuming that the threshold voltage of the transistor $N_{82}$ is 0.8 V, a potential equal to or higher than 80% of $V_{cc}$—0.8 V), the potential at the node $NO_{87}$ to be charged will be finally reaching potential while the value of the charging current $I_{cc8}$ is being reduced. Subsequently, if the second control signal $\phi_5$ becomes "1"-level, then the transistors $P_{81}$ and $P_{83}$ are turned OFF, the transistor $N_{81}$ is turned ON and the precharge control signal $\phi_6$ becomes "0"-level. After a predetermined period from that, the first control signal $\phi_1$ becomes "1"-level, so that the node $NO_{87}$ to be charged becomes "0"-level.

While three preferred embodiments and one example of application have been described above, the improvements according to the present invention will be explained.

In Fig. 10 are illustrated waveforms of the precharge signals and the charging current in the prior art and according to the present invention, respectively. In this figure, a waveform 3 is the precharge signal in the prior art shown in Fig. 1 and a waveform 4 shows a precharge sig signal according to the present invention. $I_{cc1}$ designates a waveform $I_{cc1}$ shows a charging current for a node to be charged in the prior art, while a waveform $I_{cc3}$ shows a charging current for a node to be charged according to the present invention. If potential fall arises just as the precharge control signal 3 in the prior art, then the conductance of the transistor $P_{12}$ shown in Fig. 1 would increase abruptly, and hence a large peak value appears in the charging current $I_{cc1}$ for the node $NO_{11}$ to be charged. However, as is the case with the precharge signal 4 according to the present invention, if the slope of the potential full is temporarily moderated at an intermediate potential, then the rise of the conductance of the transistor $P_{32}$ shown in Fig. 3 becomes moderate, hence the waveform of the charging current $I_{cc3}$ for the node $NO_{37}$ to be charged takes a shape of a trapezoid, and as compared to the wave form of an accute-angled isosceles triangle of the charging current $I_{cc1}$, the peak value can be reduced (for example up to 60% of the prior art) without extending the charging time, that is, while the area of the figure surrounded by the waveform and the time axis (corresponding to the total charging quantity) is maintained the same as shown in Fig. 10. In general in a printed circuit or the like on which individual parts are mounted, if a peak current upon operation of the parts is large, it would become a source of harmful noises, and therefore, reduction of a peak current is very effective.

## Claims

1. A digital circuit for charging a circuit node ($NO_{37}$, $NO_{87}$) from an initial potential to a final potential comprising first and second terminals applied with first and second power supply potentials ($V_{cc}$, ground) respectively, a first field effect transistor (P32, N82) connected between said first terminal and said circuit node and made conductive in response to a first signal ($\phi_4$, $\phi_6$) supplied to the gate thereof to charge said circuit node, a second field effect transistor (N35, N83) connected between said second terminal and said circuit node and controlled by a signal ($\phi_1$) to selectively connect or disconnect said circuit node from said second terminal, and signal producing means (30, 80) responsive to a second signal ($\phi_2$, $\phi_5$) for producing said first signal ($\phi_4$, $\phi_6$) and including level control means (P31, N31 to N34, 31 to 34; N81, P81 to P84, 81 to 84) for controlling the level of said first signal ($\phi_4$, $\phi_6$) such that it changes from a first potential related to one of said power potentials to a second potential related to the other power potential with a varying rate of change including a first rate of change (m31, m81) when the level is near said first potential, a second rate of change (m32, m82) smaller than said first rate when the level is near an intermediate level between said first and second potentials and a third rate of change (m33, m83) larger than said second rate when the level is near said second potential, characterized in that said second transistor (N35, N83) is controlled to disconnect the circuit node ($NO_{37}$, $NO_{87}$) from said second terminal at a time not later than the beginning of the change of level of said first signal ($\phi_4$, $\phi_6$), that the second potential of said first signal ($\phi_4$, $\phi_6$) does not exceed said other power potential and that the intermediate level to which said circuit node ($NO_{37}$, $NO_{87}$) is charged at the time when the first signal ($\phi_4$, $\phi_6$) changes its rate of change from said second rate (m32, m82) to said third rate (m33, m83) is a level closer to said final potential than to said initial potential.

2. The digital circuit according to claim 1, characterized in that said level control means includes an output node ($NO_{30}$, $NO_{80}$) from which said first signal is derived, a third field effect transistor (P31, N81) connected between said output node and one of said first and second terminals, fourth and fifth field effect transistors (N32 and N34; P82 and P84) connected between said output node and the other of said first and second terminals and means (31 to 34; 81 to 84) responsive to said second signal ($\phi_2$, $\phi_5$) for selectively controlling conduction of said fourth and fifth transistors to produce said first to third rate of change (m31, m32 and m33, m81, m82 and m83) in the level of said first signal.

3. The circuit according to claim 1, characterized in that said level control means includes an output node ($NO_{30}$, $NO_{80}$) a third field effect transistor (P31, P81) coupled between one of said first and second terminals and said output node, fourth and fifth field effect transistors (N32, N34, P82, P84) coupled between said output node and the other of said first and second terminals, the conductance of said fourth transistor being larger than that of said fifth transistor, means for rendering conducting said fifth transistor in response to absence of said second signal, means (31, 34, 81, 84) for rendering conducting said fourth transistor when said second signal is present and the potential at said output node is not near the intermediate level, and means (32, 33, 82, 83) for rendering non-conducting said fourth transistor at least when the potential at said output node is near the intermediate level.

## Patentansprüche

1. Digitaler Schaltkreis zur Aufladung eines Schaltkreisknotenpunktes ($NO_{37}$, $NO_{87}$) von einer Anfangsspannung auf eine Endspannung mit ersten und zweiten Anschlußklemmen, die mit ersten und zweiten Versorgungsspannungen ($V_{CC}$, ground) versorgt werden, einem ersten Feldeffekttransistor (P32, N82), der zwischen der ersten Anschlußklemme und dem Schaltkreisknotenpunkt angeschlossen ist und leitfähig gemacht wird, in Abhängigkeit von einem ersten Signal ($\phi_4$, $\phi_6$), das an sein Gate angelegt wird, um den Schaltkreisknotenpunkt aufzuladen, einem zweiten Feldeffekttransistor (N35, N83), der zwischen der zweiten Anschlußklemme und dem Schaltkreisknotenpunkt angeschlossen ist und von einem Signal ($\phi_1$) gesteuert wird, zur wahlweisen Verbindung oder Trennung des Schalt-

kreisknotenpunktes von der zweiten Anschluß-klemme, und Signalerzeugungseinrichtungen (30, 80), die auf das zweite Signal ($\phi_2$, $\phi_5$) ansprechen und beinhalten Pegelsteuereinrichtungen (P31, N31 bis N34, 31 bis 34; N81, P81 bis P84, 81 bis 84) zur Steuerung des Pegels des ersten Signals ($\phi_4$, $\phi_6$), so daß es sich ändert von einer ersten Spannung, die einer der Versorgungsspannungen entspricht, zu einer zweiten Spannung, die der anderen Versorgungsspannung entspricht, mit einer variierenden Änderungsrate, bestehend aus einer ersten Änderungsrate (m31, m81), wen der Pegel nahe der ersten Spannung ist, einer zweiten Änderungsrate (m32, m82), die kleiner ist als die erste Rate, wenn der Pegel nahe einem Zwischenpegel zwischen der ersten und zweiten Spannung, ist und einer dritten Änderungsrate (m33, m83), die größer ist als die zweite Rate, wenn der Pegel in der Nähe der zweiten Spannung ist, dadurch gekennzeichnet, daß der zweite Transistor (N35, N83) gesteuert wird zum Trennen des Schaltkreisknotenpunktes (NO37, NO87) von der zweiten Anschlußklemme, zu einer Zeit, die nicht später liegt als der Beginn der Änderung des Pegels des ersten Signals ($\phi_4$, $\phi_6$), daß die zweite Spannung des ersten Signals ($\phi_4$, $\phi_6$), nicht die andere Versorgungsspannung überschreitet, und daß der Zwischenpegel, auf welchen der Schaltkreisknotenpunkt (NO37, NO87) zu der Zeit, wenn das erste Signal ($\phi_4$, $\phi_6$) seine Änderungsrate wechselt von der zweiten Rate (m32, m82) zu der dritten Rate (m33, m83), aufgeladen wird, ein Pegel ist, der näher an dem Endpotential als an dem Anfangspotential liegt.

2. Digitaler Schaltkreis nach Anspruch 1, da-durch gekennzeichnet, daß die Pegelsteuerein-richtungen beinhalten einen Ausgangsknoten (NO30, NO80), von dem das erste Signal abgenommen wird, einen dritten Feldeffekttransistor (P31, N81), der zwischen dem Ausgangsknoten und der ersten oder zweiten Anschlußklemme angeschlossen ist, einen vierten und fünften Feldeffekttransistor (N32 und N34; P82 und P84), die zwischen dem Ausgabeknoten und der anderen der ersten und zweiten Anschlußklemmen angeschlossen sind, und Einrichtungen (31, bis 34; 81 bis 84), die auf das zweite Signal ($\phi_2$, $\phi_5$) ansprechen zur wahlweisen Steuerung der Leitfähigkeit der vierten und fünften Transistoren zur Erzeugung der ersten bis dritten Änderungsrate (m31, m32 und m33, m81, m82 und m83) im Pegel des ersten Signals.

3. Schaltkreis nach Anspruch 1, dadurch gekennzeichnet, daß die Pegelsteuereinrichtungen beinhalten einen Ausgabeknoten (NO30, NO80), einen dritten Feldeffekttransistor (P31, P81), der zwischen der ersten oder der zweiten Anschlußklemme und dem Ausgabeknoten angeschlossen ist, einen vierten und fünften Feldeffekttransistor (N32, N34, P82, P84), die zwischen dem Ausgabeknoten und der anderen der ersten und zweiten Anschlußklemme angeschlossen sind, wobei die Leitfähigkeit des vierten Transistors größer ist als die des fünften Transistors, Einrichtungen zur Durchschaltung des fünften Transistors, in Abhängigkeit von der Abwesenheit des zweiten Signals, Einrichtungen (31, 34, 81, 84) zur Durchschaltung des vierten Transistors, wenn das zweite Signal anliegt und die Spannung am Ausgabeknoten nicht in der Nähe des Zwischenpegels ist, und Einrichtungen (32, 33, 82, 83) zur Sperrschaltung des vierten Transistors zumindest wenn die Spannung am Ausgabeknoten in der Nähe des Zwischenpegels ist.

**Revendications**

1. Circuit numérique pour charger un noeud de circuit (NO37, NO87) entre un potentiel initial et une potentiel final comprenant des première et seconde bornes auxquelles sont appliqués des premier et second potentiels d'alimentation ($V_{CC}$, masse), respectivement, un premier transistor à effet de champ (P32, N82) connecté entre la première borne et le noeud de circuit et rendu conducteur en réponse à un premier signal ($\phi_4$, $\phi_6$) fourni à sa grille afin de charger le noeud de circuit, un second transistor à effet de champ (N35, N83) connecté entre la seconde borne et le noeud de circuit et commandé par un signal ($\phi_1$) de manière à connecter ou déconnecter sélectivement le noeud de circuit vis-à-vis de la seconde borne, et un moyen de production de signal (30, 80) répondant à un second signal ($\phi_2$, $\phi_5$) pour produire le premier signal ($\phi_4$, $\phi_6$) et comportant un moyen de commande de niveau (P31, N31 à N34, 31 à 34; N81, P81 à P84, 81 à 84) pour commander le niveau du premier signal ($\phi_4$, $\phi_6$) d'une façon telle qu'il passe d'un premier potentiel lié à l'un desdits potentiels d'alimentation à un second potentiel lié à l'autre potentiel d'alimentation avec un taux de variation du changement comportant un premier taux de changement (m31, m81) lorsque le niveau est proche du premier potentiel, un second taux de changement (m32, m82) inférieur au premier taux lorsque le niveau est proche d'un niveau intermédiaire entre les premier et second potentiels et un troisième taux de changement (m33, m83) supérieur au second taux lorsque le niveau est proche du second potentiel, caractérisé en ce que le second transistor (N35, N83) est commandé de manière à déconnecter le noeud de circuit (NO37, NO87) vis-à-vis de la seconde borne à un instant qui n'est pas postérieur au commencement du changement de niveau du premier signal ($\phi_4$, $\phi_6$) en ce que le second potentiel du premier signal ($\phi_4$, $\phi_6$) ne dépasse pas ledit autre potentiel d'alimentation, et en ce que le niveau intermédiaire auquel le noeud de circuit (NO37, NO87) est chargé à l'instant où le premier signal ($\phi_4$, $\phi_6$) fait passer son taux de changement du second taux (m32, m82) au troisième taux (m33, m83) est un niveau plus proche du potentiel final que du potentiel initial.

2. Circuit numérique selon la revendication 1, caractérisé en ce que le moyen de commande de niveau comporte un noeud de sortie (NO30, NO80) à partir duquel le premier signal est obtenu, un troisième transistor à effet de champ (P31, N81) connecté entre le noeud de sortie et l'une des première et seconde bornes, des quatrième et cinquième transistors à effet de champ (N32 et N34; P82 et P84) connectés entre le noeud de sortie et l'autre des première et seconde bornes et des moyens (31 à 34; 81 à 84) répondant au second signal ($\phi_2$, $\phi_5$) pour commander sélectivement la conduction des quatrième et cinquième transistors et produire les premier à troisième taux de changement (m31, m32 et m33, m81, m82 et m83) dans le niveau du premier signal.

3. Circuit selon la revendication 1, caractérisé en ce que le moyen de commande de niveau comporte un noeud de sortie ($NO_{30}$, $NO_{80}$), un troisième transistor à effet de champ (P31, P81) couplé entre l'une des première et seconde bornes et le noeud de sortie, des quatrième et cinquième transistors à effet de champ (N32, N34, P82, P84), couplés entre le noeud de sortie et l'autre des première et seconde bornes, la conductance du quatrième transistor étant supérieure à cell du cinquième transistor, un moyen permettant de rendre conducteur le cinquième transistor en réponse à l'absence du second signal, des moyens (31, 34, 81, 84) permettant de rendre conducteur le quatrième transistor lorsque le second signal est présent et le potentiel au noeud de sortie n'est pas proche du niveau intermédiaire, et des moyens (32, 33, 82, 83) permettant de rendre non conducteur le quatrième transistor au moins lorsque le potentiel au noeud de sortie est proche du niveau intermédiaire.

Fig.1

Fig.2

Fig.3

Fig. 4

1

Fig.5

Fig.6

Fig.7

## Fig.8

## Fig.9

## Fig.10